# EUROPÄISCHE PATENTANMELDUNG

(11) **EP 1 903 084 A1**
(43) Veröffentlichungstag der Anmeldung: **26.03.2008**
(21) Anmeldenummer: 07116780.3
(22) Anmeldetag: 19.09.2007
(51) Int. Cl.: C09J 133/04, C09J 7/02

(54) **Klebemasse**

(30) Priorität: 20.09.2006 DE 102006044718
(71) Anmelder: tesa AG, 20253 Hamburg (DE)
(72) Erfinder: Keite-Telgenbüscher, Klaus, Dr., 22529, Hamburg (DE); Götz, Kerstin, 22547, Hamburg (DE); Wulf, Stefan, Dr., 40166, Mönchengladbach (DE)

(57) **Zusammenfassung**

Zur Verbesserung der Verbindung von Haftklebemassen mit einem Träger oder Substrat wird eine acrylatbasierende Klebemasse mit einer Basisklebemasse und Zusatzstoffen vorgeschlagen, deren Zusatzstoffe zumindest ein modifiziertes Polydialkylsiloxan umfassen.

## Beschreibung

Die Erfindung betrifft eine acrylatbasierende Klebemasse mit einer Basisklebemasse und Zusatzstoffen, sowie ein verklebbares Flächengebilde mit zumindest einer Klebeschichtung.

Aus modernen Fertigungsprozessen wie auch aus dem Haushalt sind Verklebungen auf der Basis von Klebebändern nicht mehr wegzudenken. Als Klebebänder gelangen verklebbare Flächengebilde zum Einsatz, die einseitig oder beidseitig mit Klebemassen auf Acrylatbasis ausgerüstet sind. Üblicherweise umfassen derartige Klebebänder einen Träger zur Verbesserung der Stabilität, jedoch existieren auch so genannte Transferklebebänder, die ohne zusätzlichen Träger ausgebildet sind.

Abhängig von der Oberfläche des Trägers oder des Verklebungsuntergrundes (Substrat) kann es hierbei schwierig sein, eine Verankerung der Klebemasse auf der Oberfläche zu erreichen.

So tritt bei Verwendung von stark porösen Trägermaterialen oder bei einer Verklebung auf einem porösen Substrat häufig das Problem auf, dass ein großer Teil der Klebemasse in die poröse Struktur eindringt und somit für die Ausbildung einer Verklebung nicht mehr oder nur zu einem geringen Anteil beitragen kann. Die Durchdringung der porösen Matrix ist um so problematischer, je geringer die Viskosität der Klebemasse ist. Dies betrifft in extremer Weise etwa die Verklebung von Flächengebilden mit Klebemassen hoher Anfassklebrigkeit (dem so genannten "Tack") auf rauen Substraten oder etwa die Auftragung von Heißschmelzklebemassen (so genannten "Hotmelts") auf Papierträgern zur Fertigung von verklebbaren Flächengebilden, wie sie etwa als Verpackungsklebebänder oder zur Rollenendverklebung in der Papierherstellung verwendet werden.

Um in solchen Systemen dennoch eine stabile Verklebung zu bewirken, müsste die aufgetragene Menge an Klebemasse drastisch erhöht werden. So dringen bei Verwendung einer herkömmlichen Haftklebemasse zur Verklebung auf Papier beispielsweise 20 - 30 g/m² der Haftklebemasse bei direkter Beschichtung in die Faserstruktur des Papiers ein, weshalb insgesamt ein hoher Klebemasseauftrag von deutlich mehr als 50 g/m² erforderlich ist, um eine hinreichend stabile Verklebung zu gewährleisten. Eine derart dicke Klebeschichtung lässt sich jedoch nicht blasenfrei trocknen. Es kommt zum Auftreten von großen Blasen im Strichbild, was auch durch Anpassung der Produktionsparameter beim Auftragen und Trockenen nicht verhindert werden kann.

Um diesen Nachteil, d.h. das Eindringen der Klebemasse in eine poröse Trägermatrix zu beseitigen oder zu verringern, kann vor dem Auftragen der Klebemasse ein Schutzlack als Barriereschicht auf den Träger aufgetragen werden, der die Porenstruktur zumindest teilweise abdeckt oder versiegelt. Infolge der schlechteren Haftung der Klebemasse auf der Barriereschicht wird jedoch eine schlechte Verankerung der Klebemasse auf dem Träger erzielt, so dass beim Abziehen des Flächengebildes die Klebemasse nicht zusammen mit dem Träger abgezogen wird, sondern vielmehr auf dem Substrat verbleibt; es kommt zu einem "Umspulen" der Klebemasse vom Träger auf das Substrat. Somit ist mit derartigen Systemen ein rückstandsfreies Ablösen des Flächengebildes nicht möglich. Zudem kann dieses Verfahren nicht angewendet werden, um das Eindringen der Klebemasse in ein poröses Substrat zu verhindern. Auch bei solchen sehr glatten Oberflächen besteht somit das Problem einer Verankerung der Klebemasse.

Aufgabe der Erfindung ist es, eine acrylatbasierende Klebemasse zur Verfügung zu stellen, die eine stabile Verbindung der Klebemasse mit einer Verbindungsoberfläche wie etwa dem Substrat oder einem Träger erlaubt. Ferner soll die Erfindung ein verklebbares Flächengebilde zur stabilen Verbindung mit der Verbindungsoberfläche bereit stellen, das ein einfaches Verkleben und ein rückstandsfreies Wiederablösen vom Substrat erlaubt.

Überraschenderweise und für den Fachmann nicht nahe liegend wird diese Aufgabe erfindungsgemäß durch eine acrylatbasierende Klebemasse mit einer Basisklebemasse und Zusatzstoffen gelöst, bei der die Zusatzstoffe zumindest ein modifiziertes Polydialkylsiloxan umfassen. Die Verwendung von Polydialkylsiloxanen als Zusatzstoffe für acrylatbasierende Klebemassen bietet einerseits eine stabile Verbindung mit einem Substrat sowie eine feste Verankerung auf einem Träger, ohne dass hierdurch die klebtechnischen Eigenschaften der Basisklebemasse oder deren mechanische Eigenschaften nachteilig beeinflusst werden. Insbesondere weist die erfindungsgemäße acrylatbasierende Klebemasse eine gute Anfassklebrigkeit, hohe Scherstandzeiten und eine gute Klebkraft auf Etikettenpapier auf. Durch die erfindungsgemäße Zusammensetzung wird die Ausbildung einer stabilen Verbindung also erheblich vereinfacht, da zum Erzielen einer solchen Verklebung oder Verankerung keine zusätzlichen Vorbereitungsschritte wie das Aufbringen eines Primers oder eine physikalische Oberflächenbehandlung (z.B. Coronabehandlung) erforderlich sind.

Die Verwendung solcher modifizierter Polydialkylsiloxane ist insbesondere bei so genannten 100%-Systemen, d.h. bei Rein-Acrylatklebemassen, also Klebemassen ohne Zusatz von Lösungs- oder Dispersionsmittel, und bei lösemittelbasierten Acrylatklebemassen vorteilhaft, da insbesondere bei solchen Klebemassen eine Veränderung der Verankerungseigenschaften ohne Veränderung der klebtechnischen Eigenschaften auf andere Weise kaum möglich ist.

In einer vorteilhaften Ausgestaltung weist das zumindest eine modifizierte Polydialkylsiloxan als Modifikation Seitenketten auf, die polare Gruppen umfassen. Auf diese Weise wird eine verbesserte Verträglichkeit sowie eine hohe Klebkraft der acrylatbasierenden Klebemasse an polaren Oberflächen und somit eine stabile Verbindung der acrylatbasierenden Klebemasse mit polaren Verbindungsoberflächen erhalten.

Dabei ist es günstig, wenn die polare Gruppen umfassende Seitenkette eine Polyetherseitenkette ist. Auf diese Weise wird die Verträglichkeit besonders gut und die Verbindung zwischen der Klebemasse und der Verbindungsoberfläche besonders stabil, ohne dass die Klebkraft der acrylatbasierenden Klebemasse hierdurch beeinträchtigt wird. Insbesondere vorteilhaft ist es hierfür, wenn die Polyetherseitenkette Alkandiole mit linearer Kohlenstoffkette umfasst, die über Etherbindungen miteinander verknüpft sind, und wenn die Polyetherseitenkette über eine Alkylenkette mit der Polysiloxanhauptkette verbunden ist. Hierdurch wird ein Umspulen der acrylatbasierenden Klebemasse besonders effizient verhindert.

Des Weiteren ist eine acrylatbasierende Klebemasse besonders geeignet, wenn das zumindest eine modifizierte Polydialkylsiloxan als Modifikation arylgruppensubstituierte Alkylseitenketten aufweist. Auf diese Weise wird eine hohe Klebkraft der acrylatbasierenden Klebemasse an unpolaren Oberflächen und somit eine stabile Verbindung der acrylatbasierenden Klebemasse mit unpolaren Verbindungsoberflächen erhalten.

Von Vorteil ist ferner, wenn das modifizierte Polydialkylsiloxan ein modifiziertes Polymethylalkylsiloxan oder sogar ein modifiziertes Polydimethylsiloxan ist. Auf diese Weise wird unter anderem eine gute Einbettung der Zusatzstoffe in die Klebemasse gewährleistet. Welche Art Alkylgruppe ansonsten verwendet wird, hängt jeweils von der konkreten Zusammensetzung der Klebemasse ab.

Besonders geeignet ist die erfindungsgemäße acrylatbasierende Klebemasse, wenn das zumindest eine modifizierte Polydialkylsiloxan in der acrylatbasierenden Klebemasse zu einem Anteil von mindestens 0,005 Gew.-% und höchstens 2 Gew.-% enthalten ist. Auf diese Weise wird sichergestellt, dass einerseits die Verbindung mit der porösen Verbindungsoberfläche besonders gut ist, andererseits die Klebemasse aber auch insgesamt eine hohe Klebkraft bei hinreichender Anfassklebrigkeit aufweist.

Günstig ist es überdies, wenn die Basisklebemasse ein Grundpolymer auf der Basis von acrylatartigen Monomeren sowie optional von Vinylmonomeren umfasst. Dabei sind als acrylatartige Monomere solche besonders bevorzugt, die aus der Gruppe umfassend Acrylsäure, Methacrylsäure, Butylacrylat und Ethylhexylacrylat ausgewählt sind. Eine derartige Basisklebemasse ist besonders gut für eine Verklebung auf Papier sowie für eine Verankerung auf Trägern aus Papier, insbesondere gestrichenem oder beschichtetem Papier geeignet. Demzufolge stellt die erfindungsgemäße acrylatbasierende Klebemasse eine besonders gute Verbindung mit einer Verbindungsoberfläche aus Papier bei gleichzeitiger hervorragender Repulpierbarkeit der Klebemasse sicher.

Schließlich kann die acrylatbasierende Basisklebemasse vorteilhafterweise auch eine Haftklebemasse sein. Diese bleibt nach dem Auftragen auf den Träger dauerklebrig und kann unter Druck auf ein Substrat aufgebracht werden, wo sie eine Verklebung mit dem Substrat eingehen kann. Durch die Verwendung einer Haftklebemasse als Basisklebemasse wird ein besonders einfaches Verkleben der acrylatbasierenden Klebemasse mit unterschiedlichen Substraten möglich.

Ferner stellt die Erfindung ein verklebbares Flächengebilde mit zumindest einer Klebeschichtung bereit, bei dem die Klebeschichtung zumindest eine der zuvor beschriebenen acrylatbasierenden Klebemassen umfasst. Hierdurch wird die Verwendung der erfindungsgemäßen Klebemasse vereinfacht. Das so erhaltene Klebeband bietet sämtliche der oben beschriebenen Vorteile, insbesondere eine hinreichend niedrige Neigung zum Umspulen bei gleichzeitig hoher Klebkraft und Anfassklebrigkeit.

Als Zusatzstoff kommt erfindungsgemäß zumindest ein modifiziertes Polydialkylsiloxan zum Einsatz. Als modifiziertes Polydialkylsiloxan wird eine Verbindung verstanden, die als eine Grundstruktur ein unsubstituiertes Polydialkylsiloxan aufweist, bei dem einzelne Alkylgruppen durch modifizierende Seitenketten ersetzt sind. Die Polydialkylsiloxan-Grundstruktur kann hierbei beliebig ausgebildet sein, etwa linear, verzweigt, zyklisch oder kammartig.

Zusätzlich zu der Polydialkylsiloxan-Grundstruktur kann ein solches modifiziertes Polydialkylsiloxan gleichzeitig auch weitere Grundstrukturen aufweisen. So kann erfindungsgemäß das modifizierte Polydialkylsiloxan als Blockcopolymer ausgebildet sein, wobei zumindest einer der Polymerblöcke eine Grundstruktur aus einem unsubstituierten Polydialkylsiloxan aufweist, bei dem einzelne Alkylgruppen durch modifizierende Seitenketten ersetzt sind. Dieser zumindest eine Polymerblock wie auch weitere Polymerblöcke eines solchen modifizierten Polydialkylsiloxan-Blockcopolymers können darüber hinaus auch weitere Monomere enthalten, etwa auf der Basis ungesättigter organischer Verbindungen, beispielsweise acrylatartiger Monomere oder Vinylmonomere.

Die unsubstituierten Polydialkylsiloxane (Silikone) der Grundstrukturen weisen Ketten aus sauerstoffverbrückten Siliziumatomen als Untereinheiten auf. Innerhalb der Ketten weist jedes Siliziumatom mit Ausnahme von solchen an Verzweigungspunkten oder am Kettenende jeweils zwei verbrückende Sauerstoffatome sowie zwei identische oder unterschiedliche Alkylgruppen auf. Über jedes der verbrückenden Sauerstoffatome ist das Siliziumatom mit jeweils einem benachbarten Siliziumatom verbunden. Eine derartige unmodifizierte Untereinheit U° hat somit die allgemeine Formel -[-Si(A¹)(A²)-O-]-, wobei A¹ und A² die oben beschriebenen Alkylgruppen darstellen. Bei unmodifizierten Untereinheiten, die sich an einem Verzweigungspunkt der Kette befinden, ist eine der beiden Alkylgruppen A¹ oder A² durch eine von der Hauptkette abzweigende Polydialkylsiloxan-Nebenkette ersetzt, gegebenenfalls sind sogar beide Alkylgruppen durch Polydialkylsiloxan-Nebenketten ersetzt. Unmodifizierte Untereinheiten, die in Bezug auf die Polydialkylsiloxan-Kette endständig sind, können über das verbrückende Sauerstoffatom oder aber - von der allgemeinen Formel abweichend - direkt an einen terminierenden Rest (T¹ , T²) gebunden sein.

Die Alkylgruppen A¹ und A² können gesättigte oder ungesättigte, unverzweigte oder verzweigte, substituierte oder unsubstituierte Alkylgruppen mit einem bis dreißig Kohlenstoffatomen sein, üblicherweise eine Alkylgruppe mit einem bis achtzehn Kohlenstoffatomen (eine C₁- bis C₁₈-Alkylgruppe), günstigerweise eine C₁- bis C₁₂-Alkylgruppe und bevorzugt eine C₁- bis C₈-Alkylgruppe, zum Beispiel Methyl-, Ethyl- oder Propylgruppen.

Die Alkylgruppen A¹ und A² können hierbei gleich oder unterschiedlich sein. Ebenso kann eine an ein Siliziumatom innerhalb einer Polydialkylsiloxan-Kette gebundene Alkylgruppe A¹ einer an ein anderes Siliziumatom innerhalb derselben Polydialkylsiloxan-Kette gebundener Alkylgruppe A¹ gleich sein oder von dieser verschieden; gleiches gilt für A². Insbesondere solche Polydialkylsiloxane sind geeignet, deren Grundstruktur eine oder zwei Methylgruppen aufweist, also Polymethylalkylsiloxane oder Polydimethylsiloxane.

In einem modifizierten Polydialkylsiloxan sind gegenüber einem unmodifizierten Polydialkylsiloxan einzelne der unmodifizierten Untereinheiten durch modifizierte Untereinheiten ersetzt, so dass das Polydialkylsiloxan neben den unmodifizierten Untereinheiten auch modifizierte Untereinheiten umfasst.

Die modifizierten Untereinheiten unterscheiden sich von den unmodifizierten Untereinheiten darin, dass eine der Alkylgruppen A¹ und A² oder sogar beide durch modifizierende Seitengruppen ersetzt sind. Eine solche modifizierte Untereinheit U^{M} hat somit die allgemeine Formel -[-Si(A³)(M)-O-]- , wobei M eine modifizierende Seitengruppe und A³ eine Alkylgruppe der für die Alkylgruppen A¹ und A² beschriebenen Art ist, die mit einer oder beiden Alkylgruppen A¹ und A² identisch sein kann oder zu diesen unterschiedlich. Üblicherweise handelt es sich bei A³ um eine Methylgruppe.

Als modifizierende Seitenketten M können alle geeigneten Seitenketten verwendet werden, unpolare wie polare. Als unpolare Seitenketten können alle geeigneten unpolaren Gruppen verwendet werden. Beispielsweise können hierfür Alkylgruppen und/oder Arylgruppen und/oder arylgruppensubstituierte Alkylgruppen eingesetzt werden, insbesondere eine lineare Alkylenkette, deren eine Seite an das Siliziumatom der Hauptkette gebunden ist und deren andere Seite mit einer Arylgruppe Ar verbunden ist (Aralkylgruppen oder Aryl-Alkylen-Gruppen), also Gruppen der allgemeinen Formel -(CH₂)ₙ-Ar mit n als Anzahl der zweibindigen (zweiwertigen) Methylengruppen in der zweibindigen Alkylenkette und Ar als Arylgruppe. Alkylgruppen und Arylgruppen können hierbei ferner jeweils als Substituenten eine oder mehrere Methylgruppen aufweisen.

Als Alkylgruppen kommen alle gesättigten oder ungesättigten, unverzweigten oder verzweigten, substituierten oder unsubstituierten Alkylgruppen in Frage, etwa solche mit einem bis dreißig Kohlenstoffatomen, üblicherweise C₁- bis C₃-Alkylgruppen.

Als Arylgruppen können je nach konkreter Anwendung unterschiedliche aromatische Kohlenwasserstoffgruppen verwendet werden, beispielsweise Phenylgruppen, Naphthylgruppen und Anthrylgruppen. Diese können jeweils unsubstituiert oder substituiert vorliegen, wobei ein Wasserstoffatom oder mehrere Wasserstoffatome substituiert sein können, beispielsweise durch Methylgruppen, Ethylgruppen, Halogenatome oder dergleichen, etwa Trifluorphenylgruppen.

Als modifizierende Seitenketten M können aber auch polare Seitenketten verwendet werden. Als polare Seitenketten können sämtliche polar funktionalisierten Seitenketten verwendet werden, beispielsweise solche mit einer oder mehreren Carboxyl-, Sulfonsäure-, Phosphonsäure-, Hydroxy-, Lactam-, Lacton-, N-substituierten Amid-, N-substituierten Amin-, Carbamat-, Epoxy-, Thiol-, Alkoxy-, Cyan-, Halogenid- oder Ethergruppen. Als Seitenketten kommen etwa in Frage mit polaren Gruppen substituierte Alkyle oder Polyester, Polyether, Polythioether, Polyamide und dergleichen.

So können beispielsweise als Polyesterseitenkette aliphatische, cycloaliphatische oder aromatische Carbonsäureester eingesetzt werden, etwa Polycaprolactone und Polybutylenadipate. Die mittlere Molmasse Mₙ dieser Polyesterseitenkette liegt hierbei in einem Bereich von 200 - 3.000 g/mol. Als günstig haben sich hierbei solche Polyester herausgestellt, die mindestens drei Estergruppen aufweisen, also eine oder beide der Gruppen -C(O)O- und -OC(O)- , die miteinander linear jeweils über Alkylenketten verbunden sind, üblicherweise C₂- bis C₁₂-Alkylengruppen, insbesondere C₄- bis C₆-Alkylengruppen, etwa zweibindiges Pentylen -(CH₂)₅- . Ebenfalls günstig sind solche Polyestergruppen der allgemeinen Form -[-O-C(O)-E¹-C(O)-O-E²-O-] ⱼ- E³, wobei j die Anzahl der Polyestereinheiten darstellt und größer als 2 gewählt wird und die Gruppen E¹, E² und E³ aus substituierten und/oder unsubstituierten Alkylengruppen ausgewählt werden.

Als Polyetherseitenkette können über Etherbindungen miteinander verknüpfte Diole, etwa aromatische Diole oder Alkandiole, eingesetzt werden. Die Alkandiole als Strukturelemente des Polyethers können gesättigte oder ungesättigte, unverzweigte oder verzweigte, substituierte oder unsubstituierte Kohlenstoffgerüste mit einem bis zwölf Kohlenstoffatomen aufweisen, bevorzugt jedoch mit zwei bis acht Kohlenstoffatomen und einer linearen Kohlenstoffkette, etwa Ethylenglykol, Propandiol oder Butandiol. Die beiden Hydroxygruppen können beliebig angeordnet sein; üblicherweise werden solche mit Hydroxygruppen in α,β-Stellung oder in α,ω,-Stellung verwendet. Die Alkandiole mit Hydroxygruppen in α,β-Stellung lassen sich mit der allgemeinen Formel HO-CH₂-CH(L)-OH beschreiben, wobei L für die besonders bevorzugten Monomere Ethylenglykol, Propylenglykol bzw. Butandiol, einem Wasserstoffatom, einer Methyl- bzw. einer Ethylgruppe entspricht.

Eine Polyetherseitenkette kann dabei identische Alkandiole oder auch unterschiedliche Alkandiole umfassen, wobei in letzterem Fall eine bezüglich deren Abfolge regelmäßige Verknüpfung der Alkandiole oder aber eine statistische Verknüpfung vorliegen kann. Bevorzugt enthalten die Polyetherseitenketten in dem modifizierten Polydialkylsiloxan Ethylenglykol als Monomer zu einem Anteil von 30 Mol-%.

Je nach Anwendung können unterschiedlich viele Alkandiole in der Polyetherseitenkette miteinander verknüpft sein. Üblich ist hierbei eine Anzahl von mindestens einem und höchsten 50, insbesondere zwischen 5 und 15 oder zwischen 10 und 50 Alkandiolen.

Die polar wie auch die unpolar modifizierenden Seitenketten können an die Siliziumatome des Polydialkylsiloxans entweder direkt gebunden sein oder aber über eine weitere zweibindige Verknüpfungsgruppe mit den Siliziumatomen verbunden sein, die aus einem Sauerstoffatom, aus Alkylengruppen, aus Alkylenethergruppen, Alkylenthioethergruppen, Alkylenamidgruppen oder dergleichen bestehen kann.

Als Alkylengruppen kommen alle gesättigten oder ungesättigten, unverzweigten oder verzweigten, substituierten oder unsubstituierten zweibindigen Alkylengruppen mit 1 bis 14 Kohlenstoffatomen in Frage, bevorzugt mit 2 und 11 Kohlenstoffatomen und besonders bevorzugt mit 3 und 6 Kohlenstoffatomen.

Als Alkylenethergruppen kommen etwa solche in Frage, die zwischen 2 und 14 Kohlenstoffatome aufweisen, bevorzugt zwischen 2 und 11 Kohlenstoffatome und besonders bevorzugt zwischen 2 und 4 Kohlenstoffatome, beispielsweise -(CH₂)₂ -O-(CH₂)₄-.

Als Alkylenthioethergruppen kommen etwa solche in Frage, die zwischen 2 und 14 Kohlenstoffatome aufweisen, bevorzugt zwischen 2 und 11 Kohlenstoffatome und besonders bevorzugt zwischen 2 und 4 Kohlenstoffatome, beispielsweise -(CH₂)₂-S-CH₂-.

Als Alkylenamidgruppen kommen etwa solche in Frage, die zwischen 2 und 14 Kohlenstoffatome aufweisen, bevorzugt zwischen 2 und 11 Kohlenstoffatome und besonders bevorzugt zwischen 2 und 4 Kohlenstoffatome, beispielsweise -(CH₂)₃-NH-CH₂- oder -(CH₂)₃-NH-C(O)-.

Auf der Seite der Seitenketten, die der an den Siliziumatomen des Polydialkylsiloxans gebundenen Seite gegenüberliegt, kann die Seitenkette darüber hinaus unsubstituiert sein oder als Substituenten eine oder mehrere funktionelle terminale Gruppen aufweisen, beispielsweise eine Hydroxy-, Carboxyl-, Isocyanat-, Vinyl- oder Propenylgruppe. Bei Polyetherseitengruppen können außerdem die Substituenten auch C₁- bis C₂₂-Alkylgruppen, Phthalsäureestergruppen, -PO₃H₂ , -C(O)-CH=CH-C(O)OH , -C(O)-CH₂-CH₂-C(O)OH und davon insbesondere Methylgruppen, n-Butylgruppen und Acetoxygruppen sein. Ferner können bei Polyetherseitengruppen die funktionellen terminalen Gruppen mit dem Polyetherabschnitt der Seitenkette optional über Zwischengruppen der allgemeinen Art -(-C(O)-(CH₂)₄-O-)ₖ- oder -(-C(O)-(CH₂)₅-O -)ₖ- verbunden sein.

Neben unmodifizierten Untereinheiten kann das modifizierte Polydialkylsiloxan also entweder polar modifizierte Untereinheiten oder unpolar modifizierte Untereinheiten umfassen oder sogar beide, polar modifizierte Untereinheiten und unpolar modifizierte Untereinheiten.

Die erfindungsgemäßen modifizierten Polydialkylsiloxane können als lineare Polydialkylsiloxane somit die allgemeine Formel T¹-[(U⁰)ₓ,(U^{M})_{y}]-T² haben. Die Schreibweise [(U⁰)ₓ,(U^{M})_{y}] gibt dabei wieder, dass die Abfolge von unmodifizierten Untereinheiten und modifizierten Untereinheiten innerhalb der Polydialkylsiloxan-Kette entweder regelmäßig oder aber statistisch sein kann. Die gemittelten molaren Anteile gibt für die unmodifizierten Untereinheiten der Index x und für die modifizierten Untereinheiten der Index y wieder. Als verzweigte oder zyklische Polymere sowie als Blockcopolymere können die Polydialalkylsiloxane durch analoge allgemeine Formeln beschrieben werden.

Die endständigen Gruppen T¹ und T² können identisch oder unterschiedlich gewählt werden. So können die endständigen Gruppen T¹ und T² gewählt werden aus der Gruppe umfassend ein Wasserstoffatom, Alkyl-, Alkoxy- oder Säuregruppen und dergleichen. Beispielsweise können T¹ und/oder T² jeweils eine Methyl-, Ethyl-, Isopropyl-, Hydroxy-, Methoxy-, Ethoxy-, Isopropoxy-, Sulfonsäure-, Phosphonsäure- oder sonstige Säuregruppe sein, ohne sich durch diese Aufzählung einzuschränken. Darüber hinaus können als endständigen Gruppen T¹ und/oder T² natürlich auch eine oder mehrere der obenstehend beschriebenen modifizierenden Seitenketten vorhanden sein. Üblicherweise sind T¹ und T² Methylgruppen.

Die konkreten Werte, die x und y annehmen, sind beliebig und richten sich nach der jeweiligen Anwendung. Üblich sind für x Werte zwischen 3 und 250, insbesondere zwischen 4 und 150, und für y Werte zwischen 0 und 50, insbesondere zwischen 1 und 6; zu beachten ist, das y nur dann einen ein Wert von 0 annimmt, wenn entweder eine oder beide der endständigen Gruppen T¹ und T² eine modifizierende Seitenkette ist/sind, so dass ein modifiziertes Polydialkylsiloxan stets zumindest eine modifizierende Seitenkette aufweist.

Das Verhältnis von unmodifizierten Untereinheiten und modifizierten Untereinheiten kann entsprechend den gewünschten Anwendungen aus einem großen Bereich ausgewählt werden und wird den jeweiligen Anwendungen angepasst. Üblicherweise umfasst das modifizierte Polydialkylsiloxan mehr unmodifizierte Untereinheiten als modifizierte Untereinheiten. So ist in einem polar modifizierten Polydialkylsiloxan etwa ein Verhältnis von unmodifizierten Untereinheiten zu modifizierten Untereinheiten aus einem Bereich von 2 bis 40 üblich, insbesondere aus einem Bereich von 3 bis 30 und besonders bevorzugt aus einem Bereich von 3 bis 15. In einem unpolar modifizierten Polydialkylsiloxan sind üblicherweise bis zu 20 Gew.-% der in den unmodifizierten Untereinheiten vorhandenen Alkylgruppen A¹ und A² durch modifizierende Seitenketten ersetzt.

Die Polydialkylsiloxane werden der Klebemasse in einer geeigneten Menge zugeführt. Für die Anwendung in herkömmlichen Systemen hat sich ein Anteil von mindestens 0,005 Gew.-% und höchstens 2 Gew.-% als besonders vorteilhaft herausgestellt. Unterhalb von 0,005 Gew.-% ist der beobachtete Effekt zu gering, während oberhalb von 2 Gew.-% die Beeinträchtigung der Anfassklebrigkeit durch den Zusatzstoff zunimmt, so dass es dadurch schwieriger wird, eine Verklebung zu erzielen.

Als acrylatbasierende Klebemasse im Sinne dieser Erfindung wird jede Klebemasse bezeichnet, die neben anderen optionalen Bestandteilen eine Basisklebemasse umfasst, deren klebtechnische Eigenschaften von einem Polymer bestimmt oder zumindest in nicht unwesentlichem Maß mitbestimmt werden, dessen Grundgerüst acrylatartige Monomere aufweist.

Die Gruppe der acrylatartigen Monomere besteht aus sämtlichen Verbindungen mit einer Struktur, die sich von der Struktur von unsubstituierter oder substituierter Acrylsäure oder Methacrylsäure oder aber aus Estern dieser Verbindungen herleiten lässt, die sich durch die allgemeine Formel CH₂=C(R¹)(COOR²) beschreiben lassen, wobei der Rest R¹ ein Wasserstoffatom oder eine Methylgruppe sein kann und der Rest R² ein Wasserstoffatom sein kann oder aber aus der Gruppe der gesättigten, unverzweigten oder verzweigten, substituierten oder unsubstituierten C₁- bis C₃ₒ-Alkylgruppen gewählt ist. Vorzugsweise weist das Polymer der Basisklebemasse der acrylatbasierenden Klebemasse einen Gehalt an acrylatartigen Monomeren von 50 Gew.-% oder mehr auf.

Als acrylatartige Monomere sind grundsätzlich sämtliche der oben beschriebenen Gruppe dieser Verbindungen einsetzbar, wobei deren konkrete Auswahl und deren Mengenverhältnisse sich gemäß den jeweiligen Anforderungen aus dem beabsichtigten Anwendungsbereich bemisst.

So können etwa als acrylatartige Monomere auch solche Acryl- und Methacrylsäureester eingesetzt werden, bei denen der Rest R² aus der Gruppe der gesättigten, unverzweigten oder verzweigten, substituierten oder unsubstituierten C₄- bis C₁₄-Alkylgruppen, insbesondere C₄- bis C₉-Alkygruppen, gewählt ist. Spezifische Beispiele, ohne sich durch diese Aufzählung einschränken zu wollen, sind Methylacrylat, Methylmethacrylat, Ethylacrylat, n-Butylacrylat, n-Butylmethacrylat, n-Pentylacrylat, n-Hexylacrylat, n-Heptylacrylat, n-Octylacrylat, n-Octylmethacrylat, n-Nonylacrylat, Laurylacrylat, Stearylacrylat, Behenylacrylat, und deren verzweigten Isomere, beispielsweise Isobutylacrylat, 2-Ethylhexylacrylat, 2-Ethylhexylmethacrylat, Isooctylacrylat, Isooctylmethacrylat sowie Cyclohexylmethacrylat, Isobornylacrylat, Isobornylmethacrylat oder 3,5-Dimethyladamantylacrylat.

Desgleichen geeignet sind etwa monofunktionelle Acrylate oder Methacrylate, bei denen der Rest R² aus der Gruppe der überbrückten oder nicht-überbrückten Cycloalkylreste mit mindestens sechs Kohlenstoffatomen gewählt ist. Die Cycloalkylreste können natürlich auch substituiert vorliegen, etwa durch C₁- bis C₆-Alkylgruppen, Halogenatome oder Cyanogruppen. Spezifische Beispiele sind Cyclohexylmethacrylat, Isobornylacrylat, Isobornylmethacrylat und 3,5-Dimethyladamantylacrylat.

In einer bevorzugten Vorgehensweise werden acrylatartige Monomere eingesetzt, die einen oder mehrere Substituenten aufweisen, insbesondere polare Substituenten, beispielsweise Carboxyl-, Sulfonsäure-, Phosphonsäure-, Hydroxy-, Lactam-, Lacton-, N-substituierte Amid-, N-substituierte Amin-, Carbamat-, Epoxy-, Thiol-, Alkoxy-, Cyan-, Halogenid- und Ethergruppen.

Als Klebstoffkomponente lässt sich beispielsweise ein Polymer einsetzen, das mindestens ein acrylatartiges Monomer, bei dem R² aus der Gruppe der gesättigten, unverzweigten oder verzweigten, substituierten oder unsubstituierten C₂- bis C₂₀-Alkylgruppen gewählt wird, und mindestens ein Comonomer umfasst, wobei letzteres ein mit dem mindestens einen acrylatartigen Monomer copolymerisierbares Comonomer ist, das insbesondere aus Vinylverbindungen mit funktionellen Gruppen, Maleinsäureanhydrid, Styrol, Styrol-Verbindungen, Vinylacetat, Acrylamiden oder mit Doppelbindung funktionalisierten Photoinitiatoren gewählt werden kann. Die Mengenverhältnisse dieser Bestandteile lassen sich dabei in einem weiten Bereich variieren. So kann das acrylatartige Monomer beispielsweise einen Massenanteil von 65 bis 100 Gew.-% und das mindestens eine Comonomer einen Massenanteil von 0 bis 35 Gew.-% in dem Polymer der Basisklebemasse ausmachen.

Als Comonomere lassen sich hierbei alle geeigneten obigen Verbindungen einsetzen, etwa solche, die einen oder mehrere Substituenten aufweisen, insbesondere polare Substituenten wie etwa Carboxyl-, Sulfonsäure-, Phosphonsäure-, Hydroxy-, Lactam-, Lacton-, N-substituierte Amid-, N-substituierte Amin-, Carbamat-, Epoxy-, Thiol-, Alkoxy-, Cyan-, Halogenid- und Ethergruppen.

Als Comonomere ebenfalls geeignet sind beispielsweise moderat basische Comonomere wie einfach oder zweifach N-alkylsubstituierte Amide, insbesondere Acrylamide. Spezifische Beispiele sind N,N-Dimethylacrylamid, N,N-Dimethylmethacrylamid, N-tert-Butylacrylamid, N-Vinylpyrrolidon, N-Vinyllactam, Dimethylaminoethylacrylat, Dimethylaminoethylmethacrylat, Diethylaminoethylacrylat, Diethylaminoethylmethacrylat, N-Methylolacrylamid, N-Methylolmethacrylamid, N (Butoxymethyl)methacrylamid, N-(Ethoxymethyl)acrylamid, N-Isopropylacrylamid, wobei diese Aufzählung nicht abschließend ist.

Weitere geeignete Beispiele für Comonomere sind aufgrund der für eine Vernetzung nutzbaren funktionellen Gruppen Hydroxyethylacrylat, Hydroxyethylmethacrylat, Hydroxypropylacrylat, Hydroxypropylmethacrylat, Allylalkohol, Maleinsäureanhydrid, Itaconsäureanhydrid, Itaconsäure, Glyceridylmethacrylat, Phenoxyethylacrylat, Phenoxyethylmethacrylat, 2-Butoxyethylacrylat, 2-Butoxyethylmethacrylat, Cyanoethylacrylat, Cyanoethylmethacrylat, Glycerylmethacrylat, 6-Hydroxyhexylmethacrylat, Vinylessigsäure, Tetrahydrofurfurylacrylat, β-Acryloyloxypropionsäure, Trichloracrylsäure, Fumarsäure, Crotonsäure, Aconitsäure, Dimethylacrylsäure, wobei diese Aufzählung nicht abschließend ist.

Ferner kommen als Comonomere Vinylverbindungen in Frage, insbesondere Vinylester, Vinylether, Vinylhalogenide, Vinylidenhalogenide, Vinylverbindungen mit aromatischen Cyclen und Heterocyclen in α-Stellung. Auch hier seien nicht ausschließend einige Beispiele genannt, wie Vinylacetat, Vinylformamid, Vinylpyridin, Ethylvinylether, Vinylchlorid, Vinylidenchlorid, Styrol und Acrylnitril.

Weitere Beispiele für derartige Comonomere können Photoinitiatoren mit einer copolymerisierbaren Doppelbindung sein, insbesondere solche ausgewählt aus der Gruppe enthaltend Norrish-I- oder Norrish-II-Photoinitiatoren, Benzoinacrylate oder acrylierte Benzophenone.

Diesen Comonomeren können zusätzlich noch weitere Monomere hinzugesetzt werden, die eine hohe statische Glasübergangstemperatur besitzen. Als Komponenten eignen sich aromatische Vinylverbindungen wie zum Beispiel Styrol, wobei bevorzugt die aromatischen Kerne aus C₄- bis C₁₈-Einheiten bestehen und auch Heteroatome enthalten können. Besonders bevorzugte Beispiele sind 4-Vinylpyridin, N-Vinylphthalimid, Methylstyrol, 3,4-Dimethoxystyrol, 4-Vinylbenzoesäure, Benzylacrylat, Benzylmethacrylat, Phenylacrylat, Phenylmethacrylat, t-Butylphenylacrylat, t-Butylphenylmethacrylat, 4-Biphenylacrylat und 4-Biphenylmethacrylat, 2-Naphthylacrylat und 2-Naphthylmethacrylat sowie Mischungen aus solchen Monomeren, wobei diese Aufzählung nicht abschließend ist.

Als Basisklebemasse kommen daher solche Basisklebemassen in Frage, die als Grundpolymer ein Polymer aufweisen, das auf der Basis von acrylatartigen Monomeren sowie - optional - Vinylmonomeren gebildet ist. Als acrylatartige Monomere können wie vorstehend beschrieben insbesondere Acrylsäure, Methacrylsäure, Butylacrylat und Ethylhexylacrylat zum Einsatz kommen. Diese Bestandteile können je nach Verwendungszweck in einem weiten Bereich eingesetzt werden. So kann ein derartiges Grundpolymer beispielsweise 30 bis 60 Gew.-% Acrylsäure, 30 bis 60 Gew.-% Butylacrylat, 0 bis 40 Gew.-% Ethylhexylacrylat und 0 bis 10 Gew.-% eines Vinylmonomers umfassen. Andere rein beispielhaft aufgeführte Grundpolymere umfassen etwa 50 bis 90 Gew.-% Acrylsäure, 10 bis 50 Gew.-% Butylacrylat und 0 bis 10 Gew.-% eines Vinylmonomers oder 50 bis 90 Gew.-% Acrylsäure, 30 bis 5 Gew.-% Butylacrylat, 30 bis 5 Gew.-% Ethylhexylacrylat und 0 bis 10 Gew.-% eines Vinylmonomers, wobei diese Aufzählung keinesfalls vollständig ist.

Als Grundpolymer sind insbesondere solche acrylatbasierenden Polymere geeignet, die etwa durch radikalische Polymerisation erhältlich sind.

Die Basisklebemasse kann darüber auch weitere Rezeptierungsbestandteile umfassen, etwa Weichmacher oder Vernetzer. Ein Beispiel für eine derartige Basisklebemasse ist eine solche Klebemasse, die 25 bis 45 Gew.-% des oben beschriebenen Polymers aus acrylatartigen Monomeren und aus optionalen Vinylmonomeren, üblicherweise zu 30 bis 35 Gew.-%, umfasst, zu 55 bis 75 Gew.-% einen Weichmacher wie etwa ethoxyliertes C₂₀-Alkylamin, üblicherweise zu 65 bis 70 Gew.-%, sowie zu 0,5 bis 1,5 Gew.-% einen Vernetzer, üblicherweise zu 0,5 bis 1,0 Gew.-%. Abgesehen von der Beschränkung auf das acrylatbasierende Grundpolymer kann die Basisklebemasse beliebige Zusammensetzungen üblicher Klebemassen und beliebige Eigenschaften üblicher Klebemassen aufweisen. So kann etwa eine Haftklebemasse als Basisklebemasse eingesetzt werden. Haftklebemassen wirken bei Raumtemperatur permanent haftklebrig, weisen also eine hinreichend geringe Viskosität und eine hohe Anfassklebrigkeit auf, so dass sie die Oberfläche des jeweiligen Klebegrunds bereits bei geringem Andruck benetzen.

Die erfindungsgemäße acrylatbasierende Klebemasse kann neben der Basisklebemasse und den modifizierten Polydialkylsiloxanen selbstverständlich auch weitere Zusatzstoffe aufweisen wie zum Beispiel Füllstoffe, Pigmente, rheologische Additive, Additive zur Verbesserung der Haftung, Weichmacher, Harze, Elastomere, Alterungsschutzmittel (Antioxidantien), Lichtschutzmittel, UV-Absorber sowie sonstige Hilfs- und Zusatzstoffe, beispielsweise Trockenmittel (etwa Molekularsieb-Zeolithe, oder Calciumoxid), Fließ- und Verlaufmittel und/oder Benetzer wie Tenside oder Katalysatoren.

Als verklebbares Flächengebilde kommt jedes mit der erfindungsgemäßen acrylatbasierenden Klebemasse ausgebildete Flächengebilde in Frage. Dieses kann entweder trägerfrei ausgebildet sein (also keinen separaten Träger enthalten), beispielsweise als Transferklebeband, oder aber einen Träger aufweisen. Das Flächengebilde ist hierbei flächenartig ausgebildet, etwa als Band, Etikett, Formetikett oder Folie.

Selbstverständlich kann das verklebbare Flächengebilde überdies auch mehr als eine Klebemasse umfassen, etwa bei einer Verwendung als doppelseitiges Klebeband. Zudem ist möglich, das verklebbare Flächengebilde einseitig oder - im letztgenannten Beispiel - auch beidseitig mit einem temporären Trennmittel als Liner zu beschichten, etwa einem silikonisierten Trennpapier oder dergleichen.

Der Träger kann aus allen üblichen Trägermaterialien bestehen, starren wie flexiblen, beispielsweise aus Folien aus Polyvinylchlorid, Polypropylen, Celluloseacetat oder Polyester, aus Papier, Gewebe und dergleichen. Bei Verwendung eines nur einseitig mit Klebemasse beschichteten Trägers kann der Träger auf der Seite, die nicht mit Klebemasse beschichtet ist, auch einseitig silikonisiert vorliegen.

Zur Verbesserung der Haftung der acrylatbasierenden Klebemasse auf einer polymeren Trägerfolie kann die Folie einseitig oder beidseitig mit einem Haftvermittler versehen sein, einem so genannten Primer. Als Primer lassen sich übliche Primersysteme einsetzen, etwa Heißsiegelkleber auf der Basis von Polymeren wie Ethylvinylacetat oder funktionalisierte Ethylvinylacetate oder auch Reaktivpolymere. Als funktionelle Gruppen lassen sich dabei alle üblichen haftungssteigernden Gruppen einsetzen, etwa Epoxid-, Aziridin-, Isocyanat- oder Maleinsäureanhydridgruppen. Überdies können den Primern auch zusätzliche vernetzende Komponenten beigefügt sein, beispielsweise Melaminharze oder Melamin-Formaldehyd-Harze. Für Polyethylennaphthalat-Trägerfolien sind unter anderem Primer auf der Basis von Polyvinylidenchlorid und Copolymerisaten von Vinylidendichlorid, insbesondere mit Vinylchlorid, gut geeignet (etwa Saran der Firma The Dow Chemical Company).

Weitere Vorteile und Anwendungsmöglichkeiten gehen aus den Ausführungsbeispielen hervor, die im folgenden näher beschrieben sind.

Als Basisklebemassen wurden zwei unterschiedliche acrylatbasierende Systeme eingesetzt, in denen jeweils dasselbe herkömmliche Grundpolymer verwendet wurde. Das Grundpolymer enthielt 50,0 Gew.-% 2-Ethylhexylacrylat, 45,0 Gew.-% Acrylsäure und als vinylisches Comonomer 5,0 Gew.-% N-Vinylcaprolactam.

Als Basisklebemasse 1 wurde eine Masse aus 33,0 Gew.-% Grundpolymer, 66,0 Gew.-% Weichmacher und 1,0 Gew.-% Vernetzer eingesetzt.

Als Basisklebemasse 2 wurde eine Masse aus 34,0 Gew.-% Grundpolymer, 65,5 Gew.-% Weichmacher und 0,5 Gew.-% Vernetzer verwendet.

Beide Massen waren mit einem Feststoffanteil von 30% in einem Lösemittelgemisch aus Aceton, Isopropanol und Wasser im Verhältnis 1:1:1 gelöst.

Infolge der stark unterschiedlichen Mengen an Vernetzer unterschieden sich die beiden Basisklebemassen stark hinsichtlich ihrer klebtechnischen Eigenschaften.

Der verwendete Weichmacher war ein hydroxygruppenhaltiges ethoxyliertes C₁₂-Alkylamin ("Sinopol" der Firma Vink & Co GmbH). Als Vernetzer kam Aluminiumacetylacetonat zum Einsatz.

Um die jeweilige erfindungsgemäße acrylatbasierende Klebemasse zu erhalten wurden den Basisklebemassen modifizierten Polydialkylsiloxane in unterschiedlichen Anteilen zugesetzt. Es wurden hierbei der Basisklebemasse Polydialkylsiloxane in einer Menge von 0,0 bis 1,0 Gew.-% zugefügt, jeweils bezogen auf die Masse der flüssigen Klebemasse. Der ohne Polydialkylsiloxan erhaltene Wert wurde jeweils als Vergleichsstandard verwendet.

Als polar modifiziertes Polydialkylsiloxan wurde ein polyethermodifiziertes Polydimethylsiloxan der allgemeinen Formel (H₃C)₃Si-O-[-Si(CH₃)(M)-O-]_{y}-[-Si(CH₃)₂-O-]ₓ-Si(CH₃)₃ mit M als polar modifizierende Seitenkette der oben beschriebenen Art -(-(CH₂)ₘ-O-[-CH₂-CH(L)-O-]-Z (BYK-306 der Firma BYK Chemie GmbH) verwendet. Als unpolar modifiziertes Polydialkylsiloxan kam ein aralkylmodifiziertes Polymethylalkylsiloxan der allgemeinen Formel (H₃C)₃Si-O-[-Si(CH₃)(M)-O-]_{xy}-[-Si(CH₃)(Q)-O-]ₓ-Si(CH₃)₃ mit Q als Alkylgruppe der zuvor beschriebenen Art und M als unpolar modifizierende Seitenkette der oben beschriebenen Art -(CH₂)ₙ-Ar zum Einsatz (BYK-322 der Firma BYK Chemie GmbH).

Weiterhin wurden Vergleichsversuche mit unterschiedlichen Additiven durchgeführt, die für ähnliche Zwecke eingesetzt werden, nämlich zur Verankerung von Druckfarben und Lacken. Es handelt sich hierbei um die Produkte BYK-358N und BYK-388 der Firma BYK Chemie GmbH sowie um das Produkt Zonyl FSG der Firma Tego Chemie Service GmbH. Die Vergleichsadditive wurden den Basisklebemassen jeweils zu einem Anteil von 0,2 und 1,0 Gew.-% zugesetzt (bezogen auf die Masse der flüssigen Klebemasse).

Zum Teil lagen die Polydialkylsiloxane bzw. die Vergleichsadditive in Lösung vor. Die in den Rezepturen angegeben Mengen beziehen sich dann auf die Menge der Lösung.

Die Zusatzstoffe wurden den flüssigen Basisklebemassen in der jeweils gewünschten Konzentration zugefügt und die resultierende Klebemasse nach intensivem Durchmischen in einer Direkt- Beschichtung auf den verwendeten Träger aufgetragen, um so verklebbare Flächengebilde zu erhalten. Der Masseauftrag nach Trocknung betrug hierbei 50 g/m².

Als Träger wurde ein einseitig mit einem Vorstrich aus Polyvinylalkohol (PVOH) versehenes Papier (Flächengewicht 120 g/m², Dicke 150µm, Hersteller Thilmany Pulp & Paper) verwendet. Die Beschichtung mit der Masse erfolgte auf dem PVOH-Vorstrich.

Nach Vernetzen und Konditionieren der acrylatbasierenden Klebemassen auf dem verklebbaren Flächengebilde wurden die verklebbaren Flächengebilde für fünf Tage unter Standardbedingungen equilibriert und anschließend deren klebtechnische Eigenschaften bestimmt

Die Untersuchungen umfassten die Bestimmung der Klebekraft, der Anfassklebrigkeit, der Scherstandzeit, der Repulpierbarkeit sowie der Masseverankerung.

Die Bestimmung der Klebkraft wurde hierbei wie folgt durchgeführt: Als definierter Haftgrund wurde ein Etikettenrohpapier eingesetzt. Das zu untersuchende verklebbare Flächengebilde wurde auf eine Breite von 20 mm und eine Länge von etwa 25 cm zugeschnitten, mit einem Handhabungsabschnitt versehen und unmittelbar danach zehnmal mit einer Stahlrolle von 4 kg bei einem Vorschub von 10 m/min auf den Papierhaftgrund aufgedrückt. Unmittelbar im Anschluss daran wurde das verklebbare Flächengebilde in einem Winkel von 180 ° vom Haftgrund abgezogen und die hierfür bei Raumtemperatur benötigte Kraft gemessen. Der Messwert (in N/cm) ergab sich als Mittelwert aus drei Einzelmessungen.

Die Bestimmung der Anfassklebrigkeit wurde wie folgt durchgeführt: Als Maß für die Anfassklebrigkeit bei sehr kurzer Kontaktzeit wurde der so genannte "Rolling-Ball-Tack" gemessen. Ein etwa 30 cm langer Streifen des verklebbaren Flächengebildes wurde mit der klebenden Seite nach oben unter Spannung horizontal auf der Prüfebene befestigt. Eine Probenkugel aus Stahl (Durchmesser: 11 mm; Masse: 5,6 g) wurde mit Aceton gereinigt und für 2 h im Raumklima (Temperatur: 23 °C +/- 1 °C; relative Luftfeuchtigkeit: 50 % +/- 1 %) konditioniert. Zur Messung wurde die Stahlkugel durch Herabrollen von einer 65 mm hohen Rampe (Neigungswinkel: 21 °) im Schwerefeld der Erde beschleunigt. Von der Rampe wurde die Stahlkugel unmittelbar auf die klebende Oberfläche der Probe gelenkt. Der auf der Klebemasse bis zum Stillstand der Kugel zurückgelegte Weg wurde gemessen. Die so ermittelte Rollweglänge dient hierbei als inverses Maß für die Anfassklebrigkeit der Selbstklebemasse (d.h. je kürzer der Rollweg ist, desto höher ist die Anfassklebrigkeit und umgekehrt). Der jeweilige Messwert ergab sich (als Längenangabe in mm) aus dem Mittelwert von fünf Einzelmessungen an jeweils fünf unterschiedlichen Streifen des verklebbaren Flächengebildes.

Die Scherfestigkeit des verklebbaren Flächengebildes wurde auf einem Papierhaftgrund als Scherstandzeit bestimmt. Papierhaftgründe waren weißes Streichrohpapier mit einer Flächendichte von 60 g/m² (SRP) und Tiefdruckpapier mit einer Flächendichte von 54g/m² (Turnopress der Firma StoraEnso) (TDP). Zur Messung wurde ein Streifen des verklebbaren Flächengebildes mit einer Breite von 13 mm und einer Länge von 20 mm auf den Papierhaftgrund aufgebracht und mit konstantem Anpressdruck viermal in Längsrichtung mit einer Stahlrolle von 2 kg bei einem Vorschub von 300 mm/min aufgedrückt. Das verklebbare Flächengebilde wurde bei Raumtemperatur mit einer konstanten Scherbelastung belastet und die Zeit bis zum Abscheren als Scherstandzeit (in Minuten) gemessen. Die jeweiligen Werte der Scherstandzeit ergeben sich hierbei als Mittelwert aus drei Messungen.

Zur qualitativen Bestimmung der Wiederaufbereitbarkeit von in Wasser dispergierbaren verklebbaren Flächengebilden und Papieren wird das zu untersuchende verklebbare Flächengebilde zusammen mit einem speziellen Zellstoff zu einem in Wasser aufgeschwemmten Papierbrei verarbeitet, der Pulpe, aus der ein neues Blatt Papier erzeugt wird. Dieses Blatt wird auf klebende und nicht klebende Faserbündel (so genannte Stippen) und Restklebrigkeit geprüft. Das zu prüfende Produkt gilt als repulpierbar (Bewertung: +), wenn das erzeugte Blatt weder Stippen in größerem Umfang noch ausgeprägte Restklebrigkeit aufweist. Hierzu wird das verklebbare Flächengebilde mit dem Zellstoff verklebt und in Quadrate von 13 mm Kantenlänge zerteilt. Dieser Probe wird weiterer Zellstoff bis zu einer Gesamtmasse der Probe von 15 g hinzugefügt. Die Probe wird mit Leitungswasser in einem Aufschlagbehälter aufgeschlagen. Aus der so erhaltenen Pulpe wird mittels Blattbildner ein Blatt gefertigt, das mit Deckblatt und Pappe eingedeckt ist. Die Beurteilung der so erhaltenen Blattproben erfolgt an mindestens zwei Prüfblättern je Probe. Dazu werden von der Blattprobe Deckblatt und Pappe vorsichtig entfernt. Untersucht wird die Anzahl an Stippen, die am Deckblatt oder an der Deckpappe ankleben. Die so erhaltenen Blätter werden im Durchlicht wie auch im Auflicht qualitativ beurteilt.

Zur Untersuchung der Masseverankerung wird jeweils ein Satz von drei Abschnitten des verklebbaren Flächengebildes mit einer Breite von 20 mm und einer Länge von 25 cm auf gestrichenes Rohpapier (DIN A4, etwa Mediaprint TCF Seidenmatt 200 g/m²) geklebt und mit einer Stahlrolle von 4 kg zweimal zügig angedrückt. Für die Untersuchung wird je einer der drei Abschnitte per Hand unter gleichmäßigem Zug bei einer mittleren Abzugsgeschwindigkeit von ungefähr 300 mm/min in einem Winkel von etwa 50 ° vom Rohpapier abgezogen (Wert 0 min). Jeweils eine der drei Proben wird dabei unmittelbar nach dem Andrücken abgezogen, eine zweite nach einer Ruhezeit von 5 min und die letzte nach 30 min. Als Ergebnis kann ein Abziehen beobachtet werden, das entweder unter vollständigem oder teilweisem Umspulen der Klebemasse abläuft oder ohne Umspulen der Klebemasse. Als Umspulen bezeichnet man den Übergang der Klebemasse vom Träger auf das Substrat, wobei sich die Klebemasse vom Träger ablöst, ohne diesen zu spalten. Als Abziehen ohne Umspulen der Klebemasse wird ein Abziehen bezeichnet, bei dem es nach Abziehen der drei Klebebandstreifen an keiner Stelle zu großflächigem Umspulen der Klebemasse kommt. Die tabellierten Ergebnisse geben jeweils die gemessene prozentuale Fläche für das Auftreten eines Umspulens an.

Die mit Basisklebemasse 1 für unterschiedliche Konzentrationen an polar modifiziertem Polydialkylsiloxan erhaltenen Ergebnisse sind in Tabelle 1 dargestellt.

Die mit Basisklebemasse 2 für unterschiedliche Konzentrationen an polar modifiziertem Polydialkylsiloxan erhaltenen Ergebnisse sind in Tabelle 2 dargestellt.

Die für unterschiedliche Zusatzstoffe mit Basisklebemasse 1 erhaltenen Ergebnisse sind in Tabelle 3 dargestellt.

**Tabelle 1**

| **Menge [Gew.-%] Byk 306** | **Klebkraft [N/cm]** | **Rollweg [mm]** | **Scherstandzeit mit 5 N [min]** | | **Repulpierbarkeit** | **Umspulen [%]** | | |
|---|---|---|---|---|---|---|---|---|
| | | | **auf SRP** | **auf TDP** | | **0 min** | **5 min** | **30 min** |
| **0,0** | **3,8** | **19** | **>1200** | **>1200** | **+** | **100** | **100** | **100** |
| 0,2 | 3,7 | 54 | >1200 | >5600 | + | 85 | 90 | 95 |
| 0,4 | 3,6 | 82 | >1200 | >5600 | + | 70 | 80 | 85 |
| 0,6 | 2,4 | 156 | >1200 | >5600 | + | 35 | 50 | 50 |
| 0,8 | 2,8 | 159 | >1200 | >5600 | + | 15 | 15 | 15 |
| 1,0 | 2,0 | 224 | 818 | 4390 | + | 10 | 5 | 5 |

**Tabelle 2**

| **Menge [Gew.-%] Byk 306** | **Klebkraft [N/cm]** | **Rollweg [mm]** | **Scherstandzeit mit 5 N [min]** | | **Repulpierbarkeit** | **Umspulen [%]** | | |
|---|---|---|---|---|---|---|---|---|
| | | | **auf SRP** | **auf TDP** | | **0 min** | **5 min** | **30 min** |
| **0,0** | **4,1** | **14** | **153** | **1201** | **+** | **100** | **100** | **100** |
| 0,2 | 3,8 | 48 | 98 | 897 | + | 90 | 90 | 95 |
| 0,4 | 3,8 | 79 | 121 | 856 | + | 75 | 80 | 80 |
| 0,6 | 2,9 | 130 | 164 | 869 | + | 30 | 35 | 30 |
| 0,8 | 2,8 | 145 | 211 | 764 | + | 10 | 15 | 20 |
| 1,0 | 2,4 | 189 | 198 | 870 | + | 20 | 15 | 25 |

**Tabelle 3**

| **Zusatzstoff** | **Typ** | **Menge [Gew.-%]** | **Umspulen [%]** | | | **Repulpier barkeit** |
|---|---|---|---|---|---|---|
| | | | **0 min** | **5 min** | **30 min** | |
| **"ohne"** | | **0,0** | **100** | **100** | **100** | **+** |
| Zonyl FSG | Nichtionisches | 0,2 | 90 | 80 | 80 | |
| Zonyl FSG | Fluorpolymer | 1,0 | 80 | 85 | 90 | + |
| BYK-358N | Acrylat- | 0,2 | 80 | 90 | 90 | |
| BYK-358N | Copolymer | 1,0 | 80 | 85 | 90 | + |
| BYK-306 | Polyethermodifiz. | 0,2 | 85 | 90 | 95 | |
| BYK-306 | Polydimethylsiloxan | 1,0 | 10 | 5 | 5 | + |
| BYK-388 | Fluormodifiziertes | 0,2 | 70 | 75 | 90 | |
| BYK-388 | Polyacrylat-Copolymer | 1,0 | 85 | 80 | 95 | + |
| BYK-322 | Aralkylmodifiziertes | 0,2 | 70 | 85 | 90 | |
| BYK-322 | Polymethylalkylsiloxan | 1,0 | 65 | 80 | 90 | + |

Aus Tabellen 1 und 2 ist zu entnehmen, dass durch Verwendung eines modifizierten Polydialkylsiloxans für beide acrylatbasierende Klebemassen bereits bei einer Menge von 0,2 Gew.-% der 12%igen Lösung die Häufigkeit eines Umspulens deutlich verringert wird. Dieser Effekt ist um so ausgeprägter, je höher die der Klebemasse zugesetzte Menge an modifiziertem Polydialkylsiloxan ist. Demzufolge wird durch den erfinderischen Zusatzstoff die Masseverankerung auf dem Papierträger entscheidend verbessert. Eine sogar erhebliche Verbesserung der Verankerung wird oberhalb einer Menge von 0,6 Gew.-% der 12%igen Lösung beobachtet.

Die Scherstandzeiten und die Repulpierbarkeit werden durch das beigefügte modifizierte Polydialkylsiloxan nicht oder allenfalls in nur geringem Umfang beeinträchtigt. So sind auf beiden Papiermedien die Scherstandzeiten auch bei hohen Zusatzstoffanteilen nahezu unverändert hoch.

Überraschenderweise nimmt jedoch ebenfalls die Klebkraft in wesentlich geringerem Umfang ab als erwartet. Vor Durchführung der Versuche war davon ausgegangen worden, dass die Beimengung bereits geringster Mengen an modifizierten Polydialkylsiloxanen eine drastische Abnahme der Klebekraft der gesamten acrylatbasierenden Klebemasse zur Folge haben müsste. Dies wurde jedoch nicht beobachtet. Im Gegenteil verringert sich selbst bei einer Zugabe des Zusatzstoffes von 0,8 Gew.-% der 12%igen Lösung die Klebkraft um nur ein Weniges.

Die durch Hinzufügen des erfindungsgemäßen Zusatzstoffes am stärksten beeinträchtigte klebtechnische Eigenschaft ist die Anfassklebrigkeit. Infolge des Beimengens des modifizierten Polydialkylsiloxans verlängert sich so der Rollweg der Stahlkugel deutlich, was auf eine starke Abnahme der Anfassklebrigkeit schließen lässt. Eine Zugabe von weniger als 0,8 Gew.-% der 12%igen Lösung ergab trotz allem noch eine hervorragende Anfassklebrigkeit der acrylatbasierenden Klebemasse. Erst oberhalb von 5 Gew.-% der 12%igen Lösung wurde die Anfassklebrigkeit als nicht mehr hinreichend beurteilt.

Somit erlaubt die Verwendung eines modifizierten Polydialkylsiloxans eine stabile Verbindung der Klebemasse mit lackierten Verbindungsoberflächen unter Beibehalten der Dicke und des Flächengewichts der Klebeschichtung, ohne dass hierdurch die übrigen klebtechnisch relevanten Eigenschaften der acrylatbasierenden Klebemasse signifikant verschlechtert werden und ohne dass Festigkeitseigenschaften wie etwa Höchstzugkraft oder Reißdehnung eines unter Verwendung der acrylatbasierenden Klebemasse hergestellten Flächengebildes verschlechtert werden. Insbesondere kann die Häufigkeit eines Umspulens der Klebemasse beim Ablösen von der Verbindungsoberfläche stark verringert werden.

Aus Tabelle 3 ist zu entnehmen, dass lediglich eine Verwendung von BYK-306 und BYK-322 die Verringerung der Häufigkeit eines Umspulens zur Folge hat und dass somit auch nur diese Substanzen eine Erhöhung der Stabilität der Verbindung zwischen acrylatbasierender Klebemasse und porösem Träger bewirken. Bei Verwendung anderer üblicher Additive zur Verankerung von Druckfarben und Lacken nimmt sich gegenüber einer acrylatbasierenden Klebemasse ohne derartige Zusatzstoffe die Häufigkeit eines Umspulens innerhalb der experimentell bestimmbaren Grenzen nicht erkennbar ab. Da es sich bei der Verbindungsoberfläche um eine polyvinylalkoholmodifizerte Oberfläche aus Papier handelt, ist die Verbesserung der Verankerung bei Verwendung eines polar modifizierten Polydialkylsiloxan ausgeprägter als bei dem unpolar modifizierten Polydialkylsiloxan. Für die acrylatbasierende Klebemasse mit dem polar modifizierten Polydialkylsiloxan wird insbesondere bei einem hohen Zusatzstoffgehalt von 1,0 Gew.-% der 12%igen Lösung sofort nach dem Verkleben wie auch nach einer längeren Ruhezeit das Umspulen der Klebemasse von nahezu 100 % auf etwa 5 % gesenkt. Die Repulpierbarkeit der acrylatbasierenden Klebemassen wurde hingegen von keiner der verwendeten Zusatzstoffe erkennbar negativ beeinflusst.

## Patentansprüche

1. Acrylatbasierende Klebemasse mit einer Basisklebemasse und Zusatzstoffen,
**dadurch gekennzeichnet, dass**
die Zusatzstoffe zumindest ein modifiziertes Polydialkylsiloxan umfassen.

2. Acrylatbasierende Klebemasse nach Anspruch 1, wobei die Klebemasse ein 100%-System ist.

3. Acrylatbasierende Klebemasse nach Anspruch 1, wobei die Klebemasse eine lösemittelbasierte Klebemasse ist, vorzugsweise mit einem Lösungsmittelanteil von 20 bis 90 Gew.-%.

4. Acrylatbasierende Klebemasse nach einem der Ansprüche 1 bis 3, wobei das zumindest eine modifizierte Polydialkylsiloxan als Modifikation polare Gruppen umfassende Seitenketten aufweist.

5. Acrylatbasierende Klebemasse nach Anspruch 4, wobei die polare Gruppen umfassende Seitenkette eine Polyetherseitenkette ist.

6. Acrylatbasierende Klebemasse nach Anspruch 5, wobei die Polyetherseitenkette über Etherbindungen miteinander verknüpfte Alkandiole mit linearer Kohlenstoffkette umfasst und über eine Alkylenkette mit der Polysiloxanhauptkette verbunden ist.

7. Acrylatbasierende Klebemasse nach einem der Ansprüche 1 bis 3, wobei das zumindest eine modifizierte Polydialkylsiloxan als Modifikation arylgruppensubstituierte Alkylseitenketten aufweist.

8. Acrylatbasierende Klebemasse nach einem der vorhergehenden Ansprüche, wobei das modifizierte Polydialkylsiloxan ein modifiziertes Polymethylalkylsiloxan ist.

9. Acrylatbasierende Klebemasse nach einem der Ansprüche 1 bis 7, wobei das modifizierte Polydialkylsiloxan ein modifiziertes Polydimethylsiloxan ist.

10. Acrylatbasierende Klebemasse nach einem der vorhergehenden Ansprüche, wobei das zumindest eine modifizierte Polydialkylsiloxan in der acrylatbasierenden Klebemasse zu einem Anteil von mindestens 0,005 Gew.-% und höchstens 2 Gew.-% enthalten ist.

11. Acrylatbasierende Klebemasse nach einem der vorhergehenden Ansprüche, wobei die Basisklebemasse ein Grundpolymer auf der Basis von acrylatartigen Monomeren, die aus der Gruppe umfassend Acrylsäure, Methacrylsäure, Butylacrylat und Ethylhexylacrylat ausgewählt sind, sowie optional von Vinylmonomeren umfasst.

12. Acrylatbasierende Klebemasse nach einem der vorhergehenden Ansprüche, wobei die Basisklebemasse eine Haftklebemasse ist.

13. Verklebbares Flächengebildes mit zumindest einer Klebeschichtung, die Klebeschichtung umfassend zumindest eine acrylatbasierende Klebemasse nach einem der vorhergehenden Ansprüche.
